# EUROPEAN PATENT APPLICATION

(11) **EP 2 597 649 A1**
(43) Date of publication of application: **29.05.2013**
(21) Application number: 11306539.5
(22) Date of filing: 22.11.2011
(51) Int. Cl.: G11C 17/00

(54) **Data storage device, method for writing and reading the data storage device and use of a 3D printing machine**

(71) Applicant: Thomson Licensing, 92130 Issy-les-Moulineaux (FR)
(72) Inventor: Huetter, Ingo, 30982 Pattensen (DE); Blawat, Meinolf, 30659 Hannover (DE)
(74) Representative: Thies, Stephan

(57) **Abstract**

A data storage device 2, a method for writing the data storage device 2, a method for reading the data storage device 2 and the use of a 3D printer for manufacture of the data storage device 2 is provided. The data storage device 2 comprises a 3D structure of data layers 4. Different data layers 4 are arranged at a different distance from a surface 10 of the storage device 2 that is designated for a read access. The 3D structure of data layers 4 is designed such that, if a first data layer 4 is accessible for reading, a second and subsequent data layer 4 that is arranged at a greater distance from the surface 10 than the first data layer 4 is accessible for reading only if the first data layer 4 is removed.

## Description

### FIELD OF THE INVENTION

The invention relates to a data storage device comprising a 3D structure and to a method for writing and to a method for reading the data storage device. Further, the invention relates to the use of a 3D printing machine for manufacturing of the data storage device.

### BACKGROUND

Long term data storage is an important task in today's information society. There are several technologies for data archiving, however nearly all of them suffer from the disadvantage that the life time of the respective data storage devices is limited to several years. For example, the average life time of a hard disk is between five and ten years, the data retention time of a CD or DVD is not significantly higher. In order to overcome this technical drawback, data has to be copied from one storage medium to another storage medium in regular time intervals. This will however lead to high maintenance costs for long term data storage. Further, the read and write technology for the prior art storage media is rather complex. This may cause technical problems even in near future. Even today, it might be a challenging task to read a floppy disk. It might be difficult to find a working floppy drive and if this could be achieved, it might be difficult to find suitable software drivers and a matching hardware interface to a modern computer.

There is a need for highly stable long term data storage devices having moderate complexity, high data density and which are likely to be accessible in future.

### SUMMARY

It is an object of the invention to provide an improved data storage device, an improved method for writing and reading the data storage device and an advantageous use of a 3D printing machine.

According to an aspect of the invention, a data storage device comprising a 3D structure of data layers is provided. Different data layers of the 3D structure are arranged at a different distance from a surface of the storage device that is designated for a read access. The 3D structure of data layers is designed in such a way that, if a first data layer is accessible for reading, a second data layer that is subsequent to the first data and that is arranged at a greater distance from the surface than the first data layer, is accessible for reading only if the first data layer is removed.

The data storage device according to aspects of the invention is a one time readable storage device (commonly also referred to as a "read-once" data storage device). In other words, the data storage device is continuously destroyed during the read process. Typical prior art storage devices, such as a CD or DVD, are designed to be readable as often as desired. However, for data archiving applications, the stored data is a backup and it is not necessary to access the stored data very often. Therefore, it is reasonable to focus the design of a data storage device to a high data density to the cost of the one time readability.

By accepting that the data storage device is destroyed while it is read, it is possible to design an economic, long time stable storage media device having a high data density and which is further very likely to be accessible by further reading technologies. If a single bit structure of the data storage device according to aspects of the invention has a size which is comparable to the size of the single bit structure, i. e. the size of a dot representing bit information, in a conventional data storage medium (for example a CD or DVD), the data storage device according to aspects of the invention provides a higher data density in comparison to the prior art storage devices. This is mainly due to the fact that there is no need for a substrate, substrate layer or the like. In contrast to the data storage device according to aspects of the invention, in nearly all prior art storage technologies, for example DVD, most of the volume of the storage medium is taken by the substrate. For long term data storage, this is a significant drawback, especially for big amounts of data.

Advantageously, the full volume of the data storage device according to aspects of the invention is virtually divided into a plurality of data layers that are arranged at a different distance from the surface of the data storage device that is designated for read access. Accordingly, there is no substrate in the classical sense of a substrate. For example, the data storage device may be a cube and the full volume thereof is available for data storage. This will significantly increase the storage capacity per unit volume.

The process for reading out the data storage device according to aspects of the invention may be rather slow in comparison to prior art technologies. This is because it is necessary to remove a first data layer before read-accessing a second and subsequent data layer. However, for long term data storage, data access speed is no significant parameter.

According to another aspect of the invention, the 3D structure of data layers is a multilayer structure having a plurality of coplanar layers comprising at least the first and the second data layer. In principle, the 3D structure of data layers may be an arbitrary structure. The only technical requirement is that the data layers of the 3D structure shall be readable one by one, i. e. successively. However, the technical handling of a multilayer stack is much more feasible in comparison to complex 3D structures like e. g. a spherical shape or the like and is therefore advantageous.

According to further aspects of the invention, bit information is stored in the data layers by help of an arrangement of cavities. This arrangement of cavities will be readable by optical and/or mechanical reading technologies e. g. by scanning the surface of the data layer. The mechanical stability of the data storage device may be improved by insertion of a spacer layer that is arranged adjacent to the data layers in the multilayer structure. In other words, an alternating structure comprising a data layer, a spacer, a further data layer and a further spacer layer etc. is provided. In a data storage device comprising data layers having bit information stored in the respective data layers by help of cavities, a high density of cavities (which may occur due to a certain arrangement of bit information) may affect the mechanical stability of the data storage device. Due to the introduction of spacer layers, no specific attention with respect to the arrangement of cavities is necessary.

According to another aspect of the invention, the data layers are continuous layers and bit information is stored in the data layers by help of an arrangement of different materials having different physical properties. For example, a data layer may comprise cavities first which are subsequently filled up with a further (and different) material in order to provide a continuous layer. This will result in a reliable mechanical structure of the data layers. Advantageously, the data layers may be manufactured by applying two different types of material during manufacturing of the data layer itself. In other words, the data layers are manufactured using two different materials at the same time. No spacer layers or spacer layers having a significantly reduced thickness (in comparison to the above-mentioned embodiments) are required in a data storage device according to the aspects of the invention discussed here. Advantageously, the data density of the data storage device may be increased.

According to another aspect of the invention, a method for writing a storage device according to the above-mentioned aspects of the invention is provided. Data is received and converted into a 3D structure of data layers. Further, the 3D arrangement of data layers is manufactured by 3D printing. In the 3D printing process, data layers are arranged at different distances from a surface of the storage device that is designated for read access. An optional spacer layer may be arranged adjacent to the data layers by manufacturing the spacer layer during the 3D printing process. 3D printing is a well known process, 3D printers are commercially available products. Same or similar advantages that have been already mentioned with respect to the data storage device according to aspects of the invention also apply to the method of writing a data storage device and are therefore not mentioned.

According to another aspect of the invention a method for reading a data storage device according to the above-mentioned aspects of the invention is provided. A first data layer of the 3D arrangement of data layers is read. Subsequently, the first data layer is removed. Further subsequently, a second and subsequent data layer of the 3D structure is read, wherein this second data layer is arranged at a greater depth from the surface of the data storage device that is applied for the read access, in comparison to the first removed data layer. If an optional spacer layer is present in the 3D arrangement of data layers, this spacer layer is removed before reading the second data layer.

According to another aspect of the invention, the step of removing the first data layer and/or the spacer layer is performed by applying a mechanic removal technique, preferably by applying mechanic grinding. This technology is very likely to be available in future too and is therefore advantageous. The low processing speed is no drawback for long term data storage devices as has been outlined before. According to further aspects of the invention, other technologies may be applied for removing the first data layer and/or the spacer layer. These technologies may be: spark erosion, wet etching, dry etching and/or laser etching. These advantageous alternatives are very likely to be available in future, too.

According to another aspect of the invention, a 3D printing machine is used for manufacturing of a storage device according to the above-mentioned aspects. 3D printers are available off the shelf and are very cost effective for production of individual 3D structures. With the available resolution of 3D printers (which is expected to be even higher in near future) high data densities may be realized in a data storage device which is manufactured by such a 3D printing machine. According to aspects of the invention, any type of 3D printer may be suitable for manufacture of the data storage device. For example, a 3D printing machine using stereo lithography may be applied. By help of such a 3D printer, the data storage device may be manufactured from a liquid synthetic resin by UV hardening respective dots of the liquid resin. Further technologies (sometimes referred to as PolyJet) use printing of separate layers (one by one) and a 3D structure may be built up successively. According to another aspect of the invention, laser sintering which is known from rapid prototyping, may be a suitable technology for manufacture of the data storage device. Another technology which is applied by a suitable 3D printer is known as "fused deposition modeling". According to this method, which is comparable to an inkjet printer method, a molded resin is printed via a printer nozzle and the desired 3D structure is built up layer by layer.

### BRIEF DESCRIPTION OF FIGURE

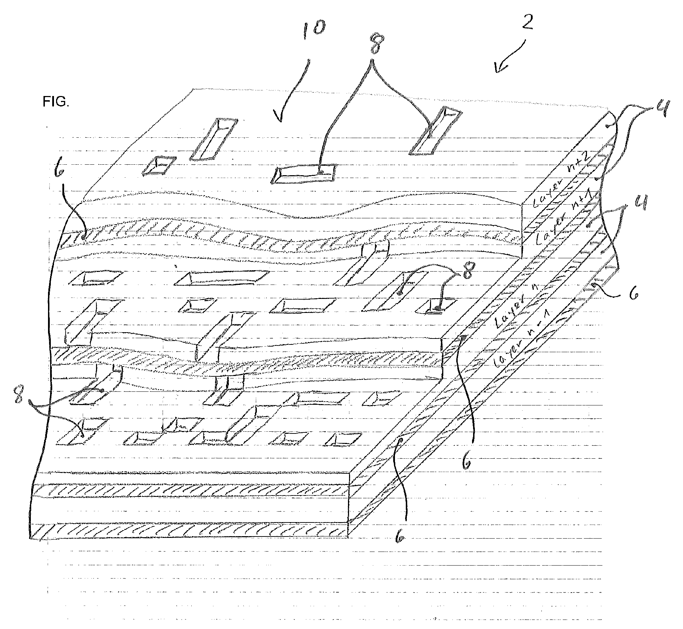

Further aspects of the invention will ensue from the following description of example embodiments with reference to the accompanying drawing, wherein the figure is a simplified perspective view to a data storage device, according to an embodiment of the invention.

### DETAILED DESCRIPTION OF EXAMPLE EMBODIMENTS

The figure is a simplified perspective detailed view to a data storage device 2 having a 3D structure of data layers 4. By way of an example only, the 3D structure of data layers 4 is a multilayer structure and the data layers 4 (i. e. layer n-1, layer n, layer n+1 and layer n+2) are substantially coplanar layers. The data layers 4 are separated by optional spacer layers 6 (see the hatched layers in figure). Bit information is stored in the data layers 4 by help of cavities 8, for the sake of clarity only several cavities 8 are given reference numerals. The data storage device 2 may be a block, e. g. a cube or a cuboid, and this block is preferably manufactured by 3D printing applying a conventional 3D printing machine.

Data is written to the data storage device 2 by subsequently manufacturing data layer 4 by data layer 4 and optional spacer layers 6 between the respective data layers 4. During manufacture of the data layers 4, the respective cavities 8 which represent the bit information remain void. According to another embodiment (not shown), the cavities 8 may be filled up with a different material after manufacture thereof. According to another embodiment, the data storage device 2 is manufactured using to different materials. The second material is applied for manufacturing data domains which represent the bit information and which remain void according to the embodiment which has been mentioned first. This second or different material differs from the material that is applied for the surrounding part of the data layer 4 in a sense that the filled cavities or data domains may be detected based upon detection of a certain property of the different material (which may be filled into the cavities 8). This different material represents the data domains in the data layers 4 and has different physical properties in comparison to the matrix material of the data layer 4. Detection of data domains is based upon these different physical properties. For example, the material of the bit domains may have a different color or a different electrical resistance when compared to the material of the surrounding data layer 4. Accordingly, bit information may be retrieved by optical inspection or by space-resolved measurement of the electrical resistance of a respective data layer 4.

The process of data readout will be outlined in the following. Data is read from the data storage device 2 by subsequently reading the data layers 4, for example in descending order, i. e. from layer n+2 to layer n+1 to layer n, etc. According to the embodiment in the figure, the upper surface 10 is designated for read access and accordingly, the uppermost data layer 4 (layer n+2) will be the first data layer 4 which is read out. The data storage device may be covered by a protection layer (not shown). Before accessing the uppermost data layer 4, this protection layer has to be removed. After the bit information from the data layer n+2 has been fully retrieved, this data layer 4 is removed. Removal of the data layer 4 and/or the protection layer may be performed for example by mechanical grinding, spark erosion, wet or dry etching or by laser etching. In other words, the data layer n+2 is destroyed after reading. If the data layer n+2 and the optional subsequent spacer layer 6 have been removed, the subsequent data layer 4 (layer n+1) is accessible for reading. Following the outlined method steps, the full data information of the data storage device 2 may be retrieved by successively reading and removing the data layers 4.

If the data storage device 2 (not shown) does not comprise spacer layers 6 and the data layers 4 are continuous layers comprising bit domains having different physical properties compared to the surrounding material of the data layer 4, the read process is comparable to the outlined method despite of the fact that there is no spacer layer 6 which has to be removed before accessing the subsequent data layer 4.

By way of an example, it is assumed that the data storage device 2 is manufactured using a 3D printer having a resolution of 800x800x1600 dpi. If it is further assumed that the data layers 4 have double the size of the spacer layers 6 (in other words, the data layers 4 are twice as thick as the spacer layers 6) a cube having an edge length of 10 cm offers a storage capacity of about 2.6 GByte.

Although the invention has been described hereinabove with reference to a specific embodiment, it is not limited to this embodiment and no doubt further alternatives will occur to the skilled person that lie within the scope of the invention as claimed.

## Claims

1. A data storage device (2) comprising a 3D structure of data layers (4), wherein different data layers (4) are arranged at a different distance from a surface (10) of the storage device (2) that is designated for a read access, wherein the 3D structure of data layers (4) is designed such that, if a first data layer (4) is accessible for reading, a second data layer (4), that is subsequent to the first data layer (4) and that is arranged at a greater distance from the surface (10) than the first data layer (4), is accessible for reading only if the first data layer (4) is removed.

2. The data storage device (2) according to claim 1, wherein the 3D structure of data layers (4) is a multilayer structure having a plurality of coplanar layers (4, 6) comprising at least the first and the second data layer (4).

3. The data storage device (2) according to claim 1 or 2, wherein bit information is stored in the data layers (4) by help of an arrangement of cavities (8).

4. The data storage device (2) according to claim 1 or 2, wherein the data layers (4) are continuous layers and bit information is stored in the data layers (4) by help of an arrangement of different materials having different physical properties.

5. The data storage device (2) according to one of claims 2 to 4, wherein the multilayer structure further comprises a spacer layer (6) that is arranged adjacent to the data layers (4).

6. A method for writing data storage device (2) according to one of claims 1 to 5, the method comprising the steps of:
a) receiving data and converting the received data into a 3D structure of data layers (4) and
b) manufacturing the 3D structure of data layers (4) by 3D printing, wherein the data layers (4) are arranged at different distances from a surface (10) of the storage device (2) that is designated for read access.

7. The method of writing according to claim 6, wherein the method further comprises the step of: manufacturing a spacer layer (6) that is arranged adjacent to the data layers (4).

8. A method for reading a data storage device (2) according to one of claims 1 to 5, the method comprising the steps of:
a) reading data of a first data layer (4) of the 3D structure of data layers (4, 6),
b) removing at least the first data layer (4) and
c) subsequently reading a second and subsequent data layer (4) that is arranged in a greater depth from the surface (10) of the data storage device (2) that is applied for the read access than the first removed data layer (4).

9. The method of reading data storage device (2) according to claim 8, the method further comprising the step of: removing a spacer layer (6) before reading the second data layer (4).

10. The method of reading a data storage device (2) according to claim 8 or 9, wherein the step of removing the first data layer (4) and/or the spacer layer (6) is performed by applying a mechanic removal technique, preferably by applying mechanic grinding.

11. The method of reading a data storage device (2) according to claim 8 or 9, wherein the step of removing the first data layer (4) and/or the spacer layer (6) is performed by applying one technique of the following group of techniques: spark erosion, wet etching, dry etching, laser etching.

12. Use of a 3D printing machine for manufacturing of a data storage device (2) according to one of claims 1 to 5.
